# EUROPEAN PATENT APPLICATION

(11) **EP 1 942 148 A1**
(43) Date of publication of application: **09.07.2008**
(21) Application number: 06821946.8
(22) Date of filing: 18.10.2006
(51) Int. Cl.: C08L 79/08, C08L 61/06, C08L 63/00, H05K 1/03

(54) **RESIN COMPOSITION, RESIN FILM, COVER LAY FILM, INTERLAYER ADHESIVE, METAL CLAD LAMINATE AND MULTILAYER PRINTED CIRCUIT BOARD**

(30) Priority: 24.10.2005 JP 2005308971; 06.09.2006 JP 2006242041
(71) Applicant: Sumitomo Bakelite Co., Ltd., Shinagawa-ku Tokyo 140-0002 (JP)
(72) Inventor: ABE, Tomoyuki, Akita-shi, Akita 011-8510 (JP); KOMIYATANI, Toshio, Akita-shi, Akita 011-8510 (JP)
(74) Representative: Müller, Christian Stefan Gerd
(86) International application number: PCT/JP2006/320768
(87) International publication number: WO 2007/049491

(57) **Abstract**

The present invention provides a resin composition for use as an adhesive material of a printed circuit board, comprising a polyimide siloxane resin. The present invention also provides a resin composition, a resin film, a cover lay film, an interlayer adhesive, a metal-clad laminate and a multilayer printed circuit board, in which flowing out during heating/pressing is prevented and which provide excellent adhesion strength. The present invention also provides a resin composition, a resin film, a cover lay film, an interlayer adhesive, a metal-clad laminate and a multilayer printed circuit board, which exhibit excellent heat resistance.

## Description

### TECHNICAL FIELD

The present invention relates to a resin composition, a resin film, a cover lay film, an interlayer adhesive, a metal-clad laminate and a multilayer printed circuit board.

### BACKGROUND ART

Recent densification of electronic devices has accelerate multi-layering of printed circuit boards used for them. Such a printed circuit board is a rigid-flex printed circuit board which is a composite substrate consisting of a flexible printed circuit board and a rigid printed circuit board, which has been expanded in application.
For a conventional multi-layer flexible printed circuit board or rigid-flex printed circuit board, there has been proposed a process where a plurality of single-sided circuit boards and adhesive layers are alternately deposited, then a through-hole is formed penetrating them for interlayer connection, the through-hole is plated for interlayer connection and then the outermost layer is processed to form a circuit, or alternatively where a hole not penetrating a copper foil in the insulator side of a one-sided circuit board is formed, a conductor post is formed from a metal or alloy, the whole surface is subjected to coating, an adhesive layer and a circuit board are pressed and these steps are repeated as needed to form a multilayer structure (for example, Japanese Laid-open Patent Publication No. H11-54934).

For multi-layering of a printed circuit board, an adhesive layer is essential for interlayer adhesion between substrates or material adhesion between a metal layer and a substrate. Conventionally used interlayer adhesives or material adhesives include urethane resins, polyester resins, epoxy resins and acrylic resins. However, these resins have the problems of flowing out of a large amount of an adhesive from between layers or between a metal layer and a substrate during heating/pressing, inadequate adhesion strength and lower heat resistance as a feature of a cured resin (for example, Japanese Laid-open Patent Publication Nos. H05-003395 and H05-218616).

Patent Document 1: Japanese Laid-open Patent Publication No. H11-54934
Patent Document 2: Japanese Laid-open Patent Publication No. H05-003395
Patent Document 3: Japanese Laid-open Patent Publication No. H05-218616

### DISCLOSURE OF THE INVENTION

According to the present invention, there are provided a resin composition, a resin film, a cover lay film, an interlayer adhesive, a metal-clad laminate and a multilayer printed circuit board, in which flowing out during heating/pressing is prevented and which provide excellent adhesion strength. According to the present invention, there are also provided a resin composition, a resin film, a cover lay film, an interlayer adhesive, a metal-clad laminate and a multilayer printed circuit board, which exhibit excellent heat resistance.

According to the present invention, there is provided a resin composition for use as an adhesive material of a printed circuit board, comprising a polyimide siloxane resin.

### BRIEF DESCRIPTION OF THE DRAWINGS

FIG. 1 is a cross-sectional view illustrating an outer one-sided circuit board for preparing a multilayer circuit board for confirming effectiveness of an adhesive layer of the present invention and a process for manufacturing it.
FIG. 2 is a cross-sectional view illustrating an inner flexible circuit board for preparing a multilayer circuit board for confirming effectiveness of an adhesive layer of the present invention and a process for manufacturing it.
FIG. 3 is a cross-sectional view illustrating a multilayer flexible printed circuit board having a four-layer structure for confirming effectiveness of an adhesive layer of the present invention and a process for manufacturing it.
FIG. 4 schematically shows an interlayer bonding area.

### BEST MODE FOR CARRYING OUT THE INVENTION

A resin composition of the present invention is a resin composition for use as an adhesive material of a printed circuit board, which contains a polyimide siloxane resin. The resin can create flexibility. Furthermore, it can improve adhesiveness to a resin film. In combination with an epoxy resin, it can provide more improved adhesiveness. In addition, addition of a reducing agent allows for strong and excellent bonding by reducing an oxide film in the surface of a solder and an oxide film in the surface of a copper foil as a connected side during electric interlayer bonding by melting a solder bump.

Furthermore, in an embodiment of the present invention, a resin composition is used not only for an adhesive material to a metal foil but also for multi-layering a plurality of printed circuit boards.

The polyimide siloxane resin contains, in its main chain skeleton, a structure represented by general formula (1): 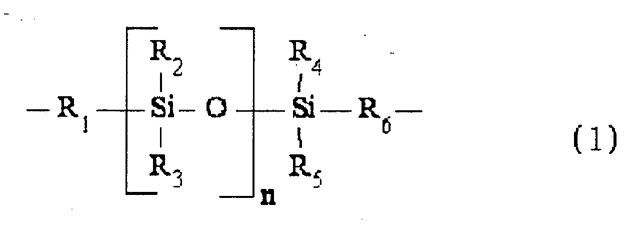 wherein R₁ and R₆ represent divalent hydrocarbon; R₂ to R₅ represent lower alkyl or phenyl; and n is an integer of 1 to 20.

There are no particular restrictions to a polyimide siloxane resin used in the present invention as long as it is soluble in a solvent. It can create flexibility in a film.
In one embodiment, the polyimide siloxane resin contains, in its main chain skeleton, structures represented by chemical formulas (1), (2) and (3). 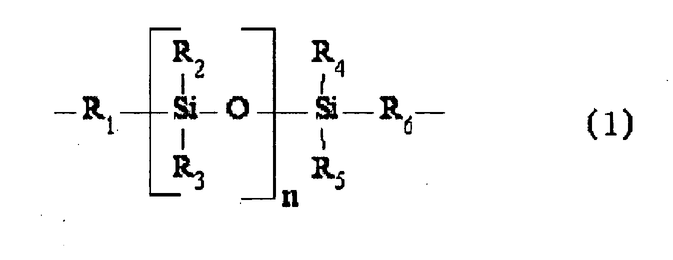 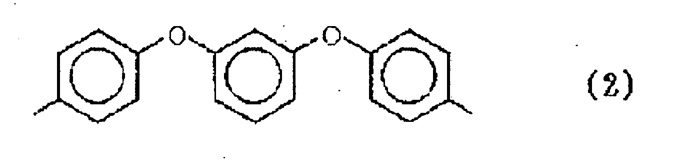 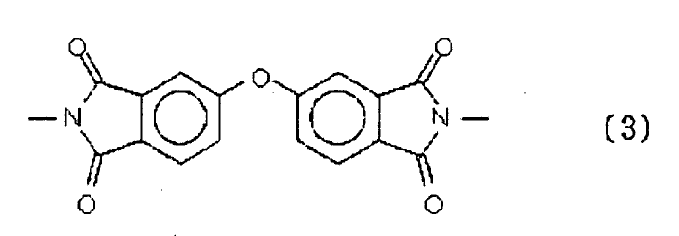 In formula (1), R₁ and R₆ represent divalent hydrocarbon; R₂ to R₅ represent lower alkyl or phenyl; and n is an integer of 1 to 20.
The above polyimide siloxane resin can be prepared by reacting a carboxylic acid component represented by general formula (4) with diamine components represented by formulas (5) and (6). 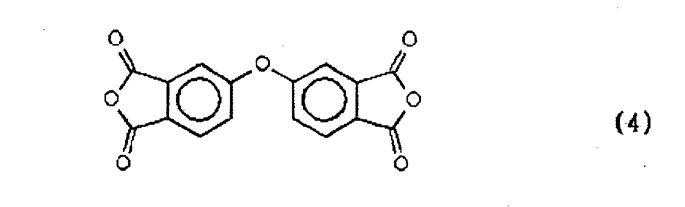 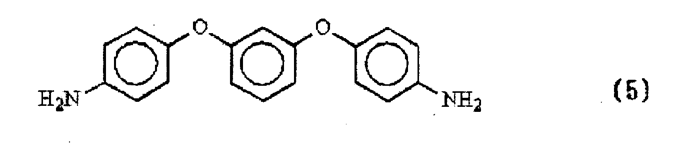 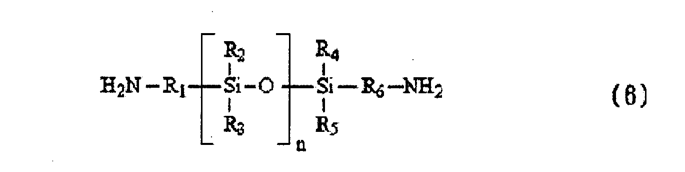 In formula (6), R₁ and R₆ represent divalent hydrocarbon; R₂ to R₅ represent lower alkyl or phenyl; and n is an integer of 1 to 20.

Preferably, a resin composition of the present invention further contains an epoxy resin. Examples of an epoxy resin used in the present invention include, but not limited to, bisphenol As, bisphenol Fs, phenol novolacs, cresol novolacs and alkylphenols having a biphenyl, a naphthalene or a dicyclopentadiene skeleton, which may be used alone or in combination of two or more.

Preferably, a resin composition of the present invention further contains a curing agent. Examples of a curing agent used in the present invention include, but not limited to, phenols, polyamines and polycarboxylic acids, which may be used alone or in combination of two or more. Examples of a phenol resin curing agent include phenol novolac resins, cresol novolac resins and bisphenol novolac resins; examples of a polyamine curing agent include dicyandiamide, diethylenetriamine, triethylenetetramine, tetraethylenepentamine and diaminodiphenyl sulfone; and examples of a polycarboxylic acid curing agent include phthalic anhydride and tetrahydrophthalic anhydride. Among these, a novolac type phenol resin is more preferable. A novolac type phenol resin preferably contains 10 % or less of a dinuclear moiety and 0.1 % or less of a free phenol. Thus, foaming can be prevented even at an elevated temperature during a bonding process by solder melting.

Preferably, a resin composition of the present invention further contains a coupling agent. There are no particular restrictions to a coupling agent used in the present invention as long as it is a commonly used coupling agent; for example, epoxy silanes, aminosilanes, mercaptosilanes, vinylsilanes, methacryloxysilanes, acryloxysilanes and isocyanate silanes. Particularly, an aminosilane is preferable. Examples of an aminosilane include N-2(aminoethyl)3-aminopropylmethyldimethoxysilane, 3-aminopropyltrimethoxysilane, 3-triethoxysilyl-N-(1,3-dimethyl-butylidene)propylamine and N-phenyl-3-aminopropyltrimethoxysilane. Among these, N-phenyl-3-aminopropyltrimethoxysilane is preferable.

Preferably, a resin composition of the present invention further contains a compound having a carboxyl group and a phenolic hydroxyl group A compound having a carboxyl group and a phenolic hydroxyl group refers to a compound having at least one carboxyl group and at least one phenolic hydroxyl group in one molecule, which may be liquid or solid. Examples of such a compound used in the present invention include, but not limited to, salicylic acid, shikimic acid, vanillic acid, phenolphthalin, Senda-chrome AL, 1,2-dicarboxy-cis-4,5-dihydroxycyclohexa-2,6-diene and 2,5-dihydroxybenzoic acid, which may be used alone or in combination of two or more. Among these, a polyphenol compound having two or more phenolic hydroxyl groups such as shikimic acid, phenolphthalin, 1,2-dicarboxy-cis-4,5-dihydroxycyclohexa-2,6-diene and 2,5-dihydroxybenzoic acid is more preferable because it is three-dimensionally incorporated into a reactant with an epoxy resin as a base resin. Its blending quantity is preferably 5 to 25 % by weight of the resin solid in the components. When it is 5 % by weight or more, an oxide film in a copper foil surface can be reduced to give strong and excellent bonding, while when it is 25 % by weight or less, handling as a film property can be improved. With the quantity within the above range, strong and excellent bonding can be achieved by reducing an oxide film in a solder surface and an oxide film in a copper foil surface as a connected surface during interlayer electric bonding by melting a solder bump.

In one embodiment, an epoxy resin is contained preferable in 20 parts by weight or more and 200 parts by weight or less to 100 parts by weight of a polyimide siloxane resin. More preferably , it is 40 parts by weight or more and 180 parts by weight or less, further preferably 50 parts by weight or more and 150 parts by weight or less. An epoxy resin rate of 20 parts by weight or more can improve adhesiveness while 200 parts by weight can improve wet heat resistance.

In one embodiment, a compound having a carboxyl group and a phenolic hydroxyl group is preferably contained in 5 parts by weight and more and 100 parts by weight or less to 100 parts by weight of a polyimide siloxane resin. More preferably, it is 10 parts by weight or more and 80 parts by weight or less.

In one embodiment, a coupling agent is preferably contained in 0.5 parts by weight or more and 10 parts by weight or less to 100 parts by weight of a polyimide siloxane resin. More preferably, it is 1 part by weight or more and 8 parts by weight or less.

In one embodiment, a resin composition of the present invention contains an inorganic filler having an average particle size of 1 nm or more and 500 nm or less.

An average particle size of the inorganic filler is preferably 1 nm or more and 500 nm or less, more preferably 1 nm or more and 200 nm or less, further preferably 1 nm or more and 50 nm or less. Since a specific surface area increases as a particle size decreases, a melt viscosity can be easily controlled even when a small amount is added.

Examples of an inorganic filler used in the present invention include alumina, mica, silica, talc, calcium carbonate, clay and titanium oxide, particularly preferably silica. Thus, a dielectric constant of a resin composition obtained can be reduced. Examples of a silica include a silica filler synthesized by sol-gel processing, a silica filler synthesized by a gas phase method, a fused silica filler and a crystalline silica filler. Particularly are preferred a silica filler synthesized by a gas phase method or a silica filler synthesized by sol-gel processing.
By adding these inorganic fillers, flowing out during heating/pressing can be improved and wet heat resistance can be improved.

For improving dispersibility of an inorganic filler in a resin, water-repelling finishing is suitably conducted using a finishing agent including a silane coupling agent such as an alkylethoxysilane, chlorosilanes such as dimethyldichlorosilane and silicone oils.
An inorganic filler is preferably contained 1 parts by weight or more and 200 parts by weight or less to 100 parts by weight of a resin composition. With an inorganic filler being contained within this range, a cured product with excellent rigidity can be obtained.

In addition to the above components, a resin composition may contain various additives such as an inorganic filler, a curing catalyst, a coloring agent, an antifoam and a flame retardant.

There will be described a resin film.
A resin film of the present invention is the above resin composition processed into a film. It can be processed into a film, for example, by applying the composition onto a releasable substrate. Examples of a releasable substrate include metal foils made of copper or a copper alloy or aluminum or an aluminum alloy; and films made of, for example, a fluororesin, a polyimide resin or a polyester resin such as polybutylene terephthalate and polyethylene terephthalate.

When applying a resin composition to a releasable substrate, it is generally applied in a form of varnish. It may improve application properties.
Although a solvent used for preparing a varnish desirably exhibits good dissolving power to a resin composition, a poor solvent may be used as long as it does not exert adverse affects. The solvent may be, for example, selected from acetone, methyl ethyl ketone, toluene, xylene, n-hexane, methanol, ethanol, methyl cellosolve, ethyl cellosolve, butyl cellosolve, methoxypropanol, cyclohexanone, N-methylpyrrolidone, dimethylformamide and dimethylacetamide, which may be used alone or in a mixture of two or more.
When preparing a varnish, a solid content of the resin composition is, but not limited to, preferably 10 % by weight or more and 90 % by weight or less, particularly preferably 30 % by weight or more and 70 % by weight or less.

A varnish can be applied on a releasable substrate and dried at 80 to 200 °C to provide a resin film.

Next, there will be described a cover lay film.
A cover lay film of the present invention can be obtained by laminating a resin film on a coating film. For example, in one embodiment, a cover lay film can be prepared by dissolving a resin composition to a predetermined concentration in a predetermined solvent to give a varnish and applying this varnish to a resin film and the drying at 80 °C or more and 150 °C or less. Examples of a coating film include polyimide films such as a polyimide film, a polyether-imide film and a polyamide-imide film; polyamide films such as a polyamide film; and polyester films such as a polyester film. Among these, a polyimide film is particularly preferable in the light of improving an elasticity modulus and heat resistance.

A thickness of the resin film is, but not limited to, preferably 1 µm or more and 100 µm or less, particularly preferably 5 µm or more and 50 µm or less. A thickness within this range can contribute to particularly excellent flexibility.

There will be described an interlayer adhesive.

A resin composition of the present invention may be used as an interlayer adhesive by applying it to a releasable substrate. Examples of a releasable substrate include metal foils made of copper or a copper alloy or aluminum or an aluminum alloy; and resin films made of, for example, a fluororesin, a polyimide resin or a polyester resin such as polybutylene terephthalate and polyethylene terephthalate.

When applying a resin composition to a releasable substrate, it is generally applied in a form of varnish. It may improve application properties.
Although a solvent used for preparing a varnish desirably exhibits good dissolving power to a resin composition, a poor solvent may be used as long as it does not exert adverse affects. The solvent may be, for example, selected from acetone, methyl ethyl ketone, toluene, xylene, n-hexane, methanol, ethanol, methyl cellosolve, ethyl cellosolve, butyl cellosolve, methoxypropanol, cyclohexanone, N-methylpyrrolidone, dimethylformamide and dimethylacetamide, which may be used alone or in a mixture of two or more.
When preparing a varnish, a solid content of the resin composition is, but not limited to, preferably 10 % by weight or more and 90 % by weight or less, particularly preferably 30 % by weight or more and 70 % by weight or less.

A varnish can be applied to a releasable substrate and dried at 80 °C or more and 200 °C or less to provide an interlayer adhesive.
A resin thickness after application and drying is preferably adjusted to a range within ±20 % of the height of a solder bump. The thickness within this range allows for excellent bonding.

Next, there will be described a metal-clad laminate.
A metal-clad laminate of the present invention is preferably prepared by applying a varnish to one side or both sides of a substrate, drying it and laminating a metal foil with the resin composition surface by thermal compression rolls.
Preferable examples of a metal constituting a metal foil include copper and copper alloys, aluminum and aluminum alloys, and iron and iron alloys, more preferably copper.
Examples of a substrate include resin films; glass fiber substrates such as glass woven fabrics and glass unwoven fabrics; inorganic fiber substrates such as woven or unwoven fabrics made of an inorganic compound other than glass; and organic fiber substrates made of organic fibers such as aromatic polyamide resins, polyamide resins, aromatic polyester resins, polyester resins, polyimide resins and fluororesins. Among these substrates, a glass fiber substrate represented by a glass woven fabric is preferable in the light of strength and water absorption. Examples of a resin film include polyimide resin films such as a polyimide resin film, a polyether-imide resin film and a polyamide-imide resin film; polyamide resin films such as a polyamide resin film; and polyester resin films such as a polyester resin film. Among these, a polyimide resin film is particularly preferable in the light of improving an elasticity modulus and heat resistance.

Although a solvent used for preparing a varnish desirably exhibits good dissolving power to a resin composition, a poor solvent may be used as long as it does not exert adverse affects. The solvent may be, for example, selected from acetone, methyl ethyl ketone, toluene, xylene, n-hexane, methanol, ethanol, methyl cellosolve, ethyl cellosolve, butyl cellosolve, methoxypropanol, cyclohexanone, N-methylpyrrolidone, dimethylformamide and dimethylacetamide, which may be used alone or in a mixture of two or more.
When preparing a varnish, a solid content of the resin composition is, but not limited to, preferably 10 % by weight or more and 90 % by weight or less, particularly preferably 30 % by weight or more and 70 % by weight or less.

There will be described a multilayer printed circuit board.
A multilayer printed circuit board of the present invention can be prepared by laminating an adhesive layer with one side or both sides of an inner circuit board having a solder bump and then melting the solder bump to form interlayer electric bonding, and during this electric bonding, an oxide film in the solder surface and an oxide film in a copper foil surface as a connected surface are reduced, resulting in strong and excellent bond. Furthermore, the resin composition of the present invention does not have to be removed by washing after solder bonding, and can be heated as it is to be converted into a three-dimensionally cross-linked resin, which gives a multilayer printed circuit board exhibiting excellent adhesiveness.
There are no particular restrictions to a heating temperature, but a first temperature for softening an adhesive is preferably 100 to 160 °C, and a subsequent second temperature for melting a solder is preferably 220 to 280 °C. Three-dimensional cross-linking of the adhesive occurs simultaneously with solder melting. If necessary, adhesiveness may be further improved by after-baking. A temperature of the process is preferably, but not limited to, 100 to 200 °C.
There are no particular restrictions to a pressure during the pressing process, but it is preferably 0.01 to 2 MPa, more preferably 0.1 to 1 MPa at the first temperature. It is preferably 0.01 to 3 MPa at the second temperature.

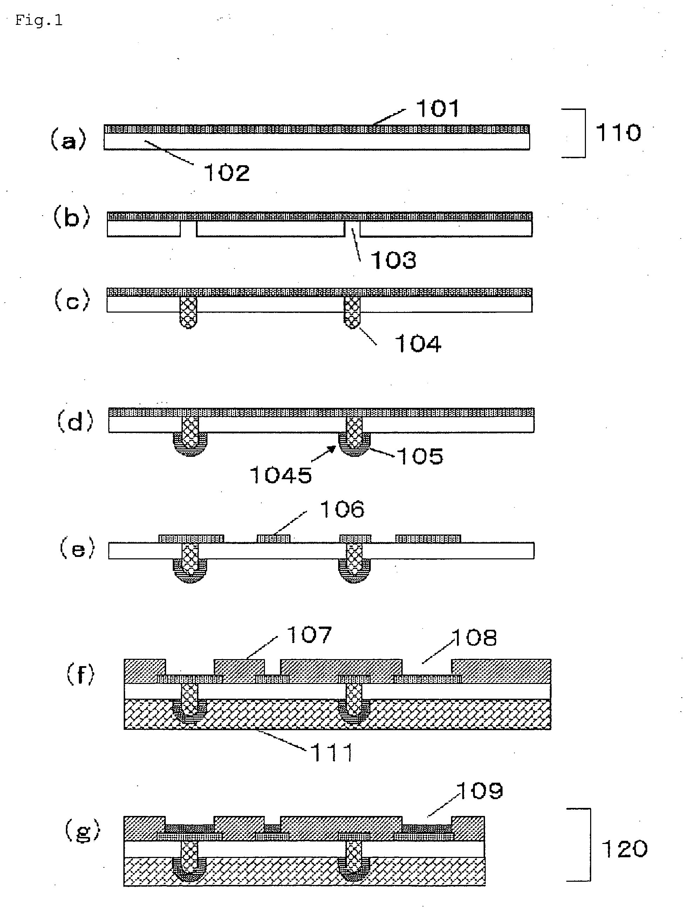

A process for manufacturing a multilayer flexible printed circuit board 310 will be described as one example of a manufacturing process for a multilayer printed circuit board.
As a first step, an outer one-sided circuit board 120 is prepared as shown in FIG. 1.
In a one-sided laminate 110 in which a copper foil 101 with a thickness of 12 µm is laminated on a supporting substrate 102 made of a polyimide film with a thickness of 25 µm (Ube Industries, Ltd., Upicel N), a supporting substrate opening 103 with a diameter of 100 µm is formed by laser irradiation from the side of the supporting substrate 102 and is desmeared with an aqueous solution of potassium permanganate. The inside of the supporting substrate opening 103 is electrolytically copper-plated such that a via post 104 is formed to a height of 15 µm from the surface opposite to the side of the copper foil 101 in the supporting substrate 102, and then a solder plating 105 is formed to a thickness of 15 µm to form a conductor post 1045. Subsequently, the copper foil 101 in the one-sided laminate 110 is etched to form an interconnection pattern 106, a liquid resist (Hitachi Chemical Co., Ltd., SR9000W) is applied by printing to form a surface coating 107, then an opening 108 is formed and a surface covering 109 is applied. Next, an interlayer adhesive of the present invention with a thickness of 25 µm (developed in house, DBF) 111 is formed by lamination using a vacuum laminator. Finally, the product is shaped into the size of a laminate to provide an outer one-sided circuit board 120.

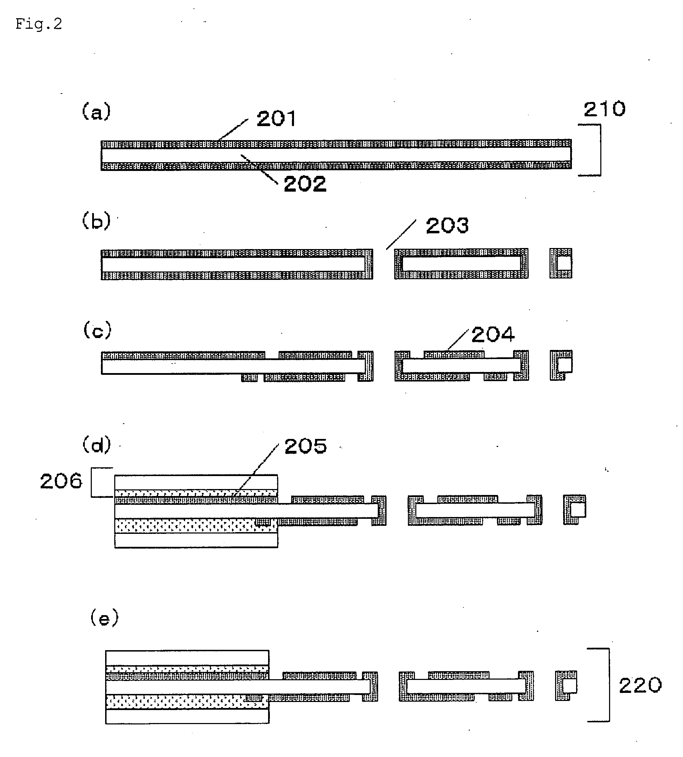

As a second step, an inner flexible circuit board 220 is prepared as shown in FIG. 2.
A two-layer two-sided plate 210 (Mitsui Chemicals, Inc., NEX23FE(25T)) consisting of a copper foil 201 with a thickness of 12 µm and a supporting substrate 202 with a thickness of 25 µm is drilled to form a hole, which is directly plated by electrolytic copper plating to form a through-hole 203 for electric conduction between the sides. Then, it is etched to form a pad 204, which can receive the interconnection pattern 106 and the conductor post 1045. Subsequently, in the part of the interconnection pattern 205 corresponding to a flexible part 330, a surface covering 206 is formed by applying a thermosetting adhesive (a material developed in house) to a thickness of 25 µm on a polyimide (Kanegafuchi Chemical Ind. Co., Ltd., Apical NPI) with a thickness of 12.5 µm. Finally, the product is cut into a predetermined outer shape to provide an inner flexible circuit board 220.

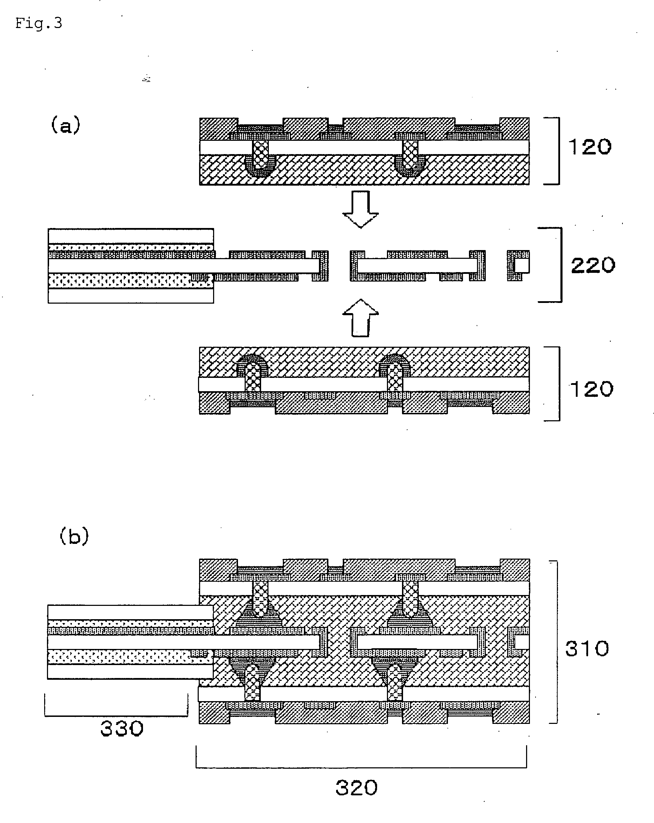

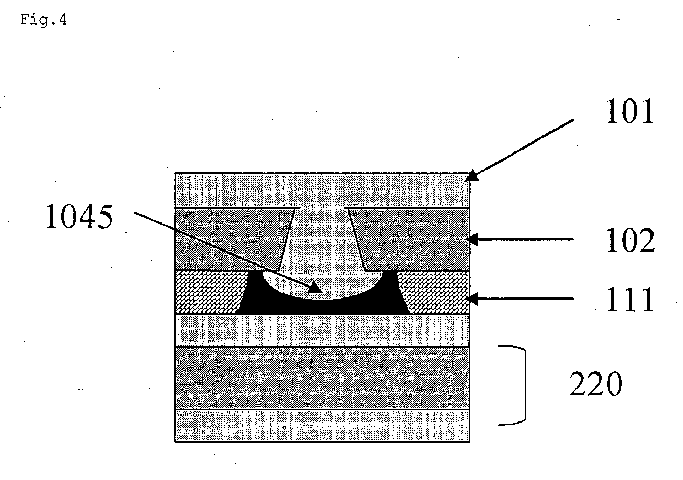

As a third step, a multilayer flexible printed circuit board 310 is prepared as shown in FIG. 3.
The outer one-sided circuit board 120 is laid-up to the inner flexible circuit board 220 using a jig with a pin guide for alignment. Then, they are temporarily and partially adhered using a spot heater at 250 °C. Next, they are laminated at 150 °C and 0.8 MPa for 90 sec using a vacuum press such that the conductor post comes into contact with the conductor pad and the circuit in the inner flexible circuit board 220 having the conductor pad is shaped and buried. Then, the product is pressed by a hydraulic press at 260 °C and 0.1 MPa for 60 sec, and the conductor post 1045 is subjected to solder-fused junction with the pad 204 in the inner flexible circuit board 220 through an interlayer adhesive of the present invention (developed in house, DBF) 111 with a thickness of 25 µm to form solder bonding and a solder fillet for interlayer bonding. Subsequently, the product is heated at 180 °C for 60 min for curing the adhesive to provide a multilayer flexible printed circuit board 310 where the layers are laminated. FIG. 4 schematically shows the interlayer bonding.

### EXAMPLES

This invention will be more specifically described with reference to, but not limited to, Examples.

For confirming effectiveness of a resin composition, a resin film, a cover lay film, an interlayer adhesive, a metal-clad laminate and a multilayer printed circuit board of the present invention, the above-mentioned multilayer flexible printed circuit boards 310 were prepared and evaluated. The results are shown in Table 1.

### Example 1

### 1. Synthesis of a polyimide siloxane resin

To a four-necked flask equipped with an inlet tube for dry nitrogen gas, a reflux condenser, a thermometer and a stirrer was charged 674 g of dry and purified N-methyl-2-pyrrolidone (NMP), and the mixture was vigorously mixed for 10 min under nitrogen gas stream. Next, to the mixture were added 31 g of 2,2-bis(4-(4-aminophenoxy)phenyl)propane (0.15 moles), 25 g of 1,3-bis(3-aminopropyl)-1,1,3,3-tetramethyldisiloxane) (0.20 moles), 51 of 4,4'-methylenedi-2,6-xylidine (0.40 moles), 26 g of 4,4-diaminodicyclohexylmethane (0.25 moles), and the mixture was stirred until it became homogeneous. After obtaining a homogeneous solution, the system was cooled to 5 °C in an ice-water bath, and 172 g of 3,4,3',4'-biphenyltetracarboxylic acid dianhydride (0.90 moles), 15 g of 3,3',4,4'-benzophenone tetracarboxylic acid dianhydride (0.09 moles) and 2 g of trimellitic anhydride (0.01 moles) were added as powders over 15 min, and the mixture was stirred for two hours. Then, the flask was kept at 5 °C.
Subsequently, the nitrogen inlet tube and the reflux condenser were removed and the flask was equipped with a Dean-Stark apparatus filled with xylene, and 170 g of toluene was added to the system. After replacing the bath with an oil bath, the system was heated to 170 °C while removing water generated from the system. After heating for 4 hours, no further generation of water from the system was observed. After cooling, the reaction solution was poured into a large amount of methanol to precipitate a polyimide siloxane. The solid was collected by filtration and dried in vacuo at 80 °C for 12 hours to remove the solvent to provide 227.79 g of a solid resin (yield: 92.1 %). Infrared absorption spectrometry using a KBr tablet method indicated absorption at 5.6 µm derived from a cyclic imide bond, but not absorption at 6.06 µm derived from an amide bond, demonstrating that substantially 100 % of the resin was imidated.

### 2. Formulation

Forty parts by weight of a bisphenol-A type epoxy resin (Dainippon Ink And Chemicals, Incorporated, EPICLON 840-S), 20 parts by weight of a novolac type phenol resin (Sumitomo Bakelite Co., Ltd., PR-53647), 20 parts by weight of the polyimide siloxane resin obtained above, 20 parts by weight of salicylic acid (Kanto Chemical Co., Inc., Reagent grade) and 100 parts by weight of NMP were weighed, and mixed and stirred to give a varnish.

The above varnish was applied to an antistatic-treated PET film with a thickness of 25 µm as a releasable substrate by a comma knife type coater such that a thickness after drying became 25 µm, and then dried to form a substrate (DBF) having a sheet reducible adhesive layer reductive adhesive layer. This was used as an interlayer adhesive between printed circuit boards as described above, to prepare a multilayer flexible printed circuit board 310. Then, it was evaluated.

### Example 2

Forty parts by weight of a bisphenol-A type epoxy resin (Dainippon Ink And Chemicals, Incorporated, EPICLON 840-S), 40 parts by weight of an ester resin (Dainippon Ink And Chemicals, Incorporated, EXB-9451-65T), 20 parts by weight of the polyimide siloxane resin obtained above, 20 parts by weight of salicylic acid (Kanto Chemical Co., Inc., Reagent grade) and 100 parts by weight of NMP were weighed, and mixed and stirred to give a varnish. As described in Example 1, it was applied to an adhesive thickness of 25 µm by a comma coater and dried, and then a multilayer flexible printed circuit board was prepared and evaluated.

### Example 3

Forty parts by weight of a bisphenol-F type epoxy resin (Dainippon Ink And Chemicals, Incorporated, EPICLON 830-S), 30 parts by weight of a dicyclopentadiene type epoxy resin (Dainippon Ink And Chemicals, Incorporated, HP-7200), 30 parts by weight of a novolac type phenol resin (Sumitomo Bakelite Co., Ltd., PR-53647), 20 parts by weight of the polyimide siloxane obtained above, 20 parts by weight of salicylic acid (Kanto Chemical Co., Inc., Reagent grade) and 100 parts by weight of NMP were weighed, and mixed and stirred to give a varnish. As described in Example 1, it was applied to an adhesive thickness of 25 µm by a comma coater and dried, and then a multilayer flexible printed circuit board was prepared and evaluated.

### Example 4

A multilayer flexible printed circuit board was prepared as described in Example 1, substituting phenolphthalin (Kanto Chemical Co., Inc., Reagent grade) for salicylic acid. Then, it was evaluated as described above.

### Example 5

Twenty parts by weight of a bisphenol-A type epoxy resin (Dainippon Ink And Chemicals, Incorporated, EPICLON 840-S), 20 parts by weight of a novolac type phenol resin (Sumitomo Bakelite Co., Ltd., PR-53647), 40 parts by weight of the polyimide siloxane resin obtained above, 20 parts by weight of salicylic acid (Kanto Chemical Co., Inc., Reagent grade), 100 parts by weight of NMP and 3 parts by weight of an aminosilane coupling agent (Shin-Etsu Chemical Co., Ltd., KBM-573) were weighed, and mixed and stirred to give a varnish. As described in Example 1, it was applied to an adhesive thickness of 25 µm by a comma coater and dried, and then a multilayer flexible printed circuit board was prepared and evaluated.

### Example 6

A multilayer flexible printed circuit board was prepared as described in Example 5, substituting a mercaptosilane coupling agent (Shin-Etsu Chemical Co., Ltd., KBM-803) for the aminosilane coupling agent. Then, it was evaluated as described above.

### Example 7

Thirty parts by weight of a bisphenol-A type epoxy resin (Dainippon Ink And Chemicals, Incorporated, EPICLON 840-S), 20 parts by weight of a novolac type phenol resin (Sumitomo Bakelite Co., Ltd., PR-53647), 30 parts by weight of the polyimide siloxane resin obtained above, 20 parts by weight of salicylic acid (Kanto Chemical Co., Inc., Reagent grade), 100 parts by weight of NMP and 3 parts by weight of an aminosilane coupling agent (Shin-Etsu Chemical Co., Ltd., KBM-573) were weighed, and mixed and stirred to give a varnish. As described in Example 1, it was applied to an adhesive thickness of 25 µm by a comma coater and dried, and then a multilayer flexible printed circuit board was prepared and evaluated.

### Example 8

Forty parts by weight of a bisphenol-A type epoxy resin (Dainippon Ink And Chemicals, Incorporated, EPICLON 840-S), 20 parts by weight of a novolac type phenol resin (Sumitomo Bakelite Co., Ltd., PR-53647), 20 parts by weight of the polyimide siloxane resin obtained above, 20 parts by weight of salicylic acid (Kanto Chemical Co., Inc., Reagent grade), 100 parts by weight of a silica filler (Nippon Aerosil Co., Ltd., average particle size: 16 nm) and 100 parts by weight of NMP were weighed, and mixed and stirred to give a varnish. As described in Example 1, it was applied to an adhesive thickness of 25 µm by a comma coater and dried, and then a multilayer flexible printed circuit board was prepared and evaluated.

### Comparative Example 1

A multilayer flexible printed circuit board was prepared and evaluated as described in Example 1, substituting a phenoxy resin (Japan Epoxy Resins Co., Ltd., YL-6954, Number average molecular weight: 14, 500) for the polyimide siloxane resin.

### Comparative Example 2

A multilayer flexible printed circuit board was prepared and evaluated as described in Example 1, substituting a phenoxy resin (Japan Epoxy Resins Co., Ltd., YL-6954, Number average molecular weight: 30, 000) for the polyimide siloxane resin.

### Comparative Example 3

A multilayer flexible printed circuit board was prepared and evaluated as described in Example 1, except that 60 parts by weight of the bisphenol-A type epoxy resin (Dainippon Ink And Chemicals, Incorporated, EPICLON 840-S) and 0 parts by weight of the polyimide siloxane resin were used.

**Table 1**

| | Flowing out of a resin after bonding | Microscopic observation of a solder bonding area | Peeling strength | Wet solder reflow test | Temperature cycle test | Insulating resistance after moisture absorption |
|---|---|---|---|---|---|---|
| Ex. 1 | OK | Good | OK | OK | OK | OK |
| Ex. 2 | OK | Good | OK | OK | OK | OK |
| Ex. 3 | OK | Good | OK | OK | OK | OK |
| Ex. 4 | OK | Good | OK | OK | OK | OK |
| Ex. 5 | OK | Good | OK | OK | OK | OK |
| Ex. 6 | OK | Good | OK | OK | OK | OK |
| Ex. 7 | OK | Good | OK | OK | OK | OK |
| Ex. 8 | OK | Good | OK | OK | OK | OK |
| Comp. Ex. 1 | NG | Good | OK | NG | OK | OK |
| Comp. Ex. 2 | NG | Good | OK | NG | OK | OK |
| Comp. Ex. 3 | A film cannot be formed | - | - | - | - | - |

- A flow-out amount of a resin after bonding was determined and 1 mm or less was accepted.
- Solder bonding area: A cross section of a solder bonding area was visually observed using a microscope.
- Peeling strength: A 90 ° peeling strength was determined and 0.5 N/mm or more was accepted.
- Wet reflow: After treatment at 30 °C and 60 % for 168 hours, solder reflowing at the maximum temperature of 260 °C was repeated three times and a product without detachment or delamination was accepted.
- Temperature cycle test: Conduction resistances before and after 1,000 cycles of -65 °C/30 min and 125 °C/30 min were determined and a percentage change of 10 % or less was accepted.
- Insulating resistance: An insulating resistance of 108 Ω or more after treatment at 30 °C/85 %/DC50V for 240 hours was accepted.

## Claims

1. A resin composition for use as an adhesive material of a printed circuit board, comprising a polyimide siloxane resin.

2. The resin composition according to Claim 1, wherein said polyimide siloxane resin contains the structure represented by general formula (1) in a main chain skeleton: 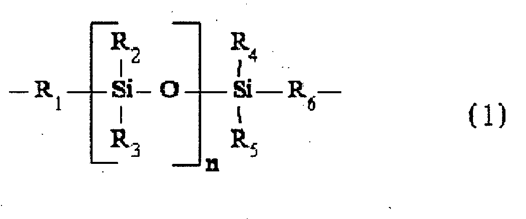 wherein R₁ and R₆ represent divalent hydrocarbon; R₂ to R₅ represent lower alkyl or phenyl; and n is an integer of 1 to 20.

3. The resin composition according to Claim 2, wherein said polyimide siloxane resin contains the structures of general formulas (1), (2) and (3) in a main chain skeleton: 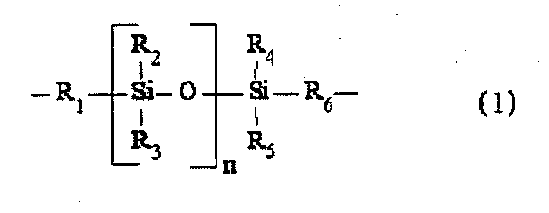 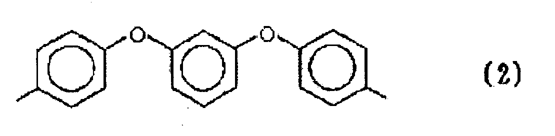 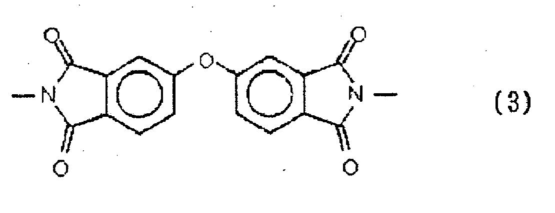 wherein R₁ and R₆ represent divalent hydrocarbon; R₂ to R₅ represent lower alkyl or phenyl; and n is an integer of 1 to 20.

4. The resin composition according to Claim 1, further comprising an epoxy resin.

5. The resin composition according to Claim 1, further comprising a curing agent.

6. The resin composition according to Claim 5, wherein said curing agent comprises a novolac type phenol resin.

7. The resin composition according to Claim 6, wherein said novolac type phenol resin contains 10 % or less of a dinuclear moiety and 0.1 % or less of a free phenol.

8. The resin composition according to Claim 1, further comprising a coupling agent.

9. The resin composition according to Claim 8, wherein said coupling agent is an aminosilane.

10. The resin composition according to Claim 1, further comprising a compound having a carboxyl group and a phenolic hydroxyl group.

11. The resin composition according to Claim 10, wherein said compound having a carboxyl group and a phenolic hydroxyl group is a polyphenol.

12. The resin composition according to Claim 1, further comprising an inorganic filler having an average particle size of 1 nm or more and 500 nm or less.

13. The resin composition according to Claim 12, wherein said inorganic filler contains alumina or silica.

14. The resin composition according to Claim 4, wherein said epoxy resin is contained in 20 parts by weight or more and 200 parts by weight or less to 100 parts by weight of said polyimide siloxane resin.

15. The resin composition according to Claim 8, wherein said coupling agent is contained in 0.5 parts by weight or more and 10 parts by weight or less to 100 parts by weight of said polyimide siloxane resin.

16. The resin composition according to Claim 10, wherein said compound having a carboxyl group and a phenolic hydroxyl group is contained in 5 parts by weight or more and 100 parts by weight or less to 100 parts by weight of said polyimide siloxane resin.

17. The resin composition according to Claim 12, wherein a content of said inorganic filler is 1 parts by weight or more and 200 parts by weight or less to 100 parts by weight of the resin composition.

18. A resin film prepared from the resin composition a according to any one of Claims 1 to 17.

19. A cover lay film prepared by laminating the resin film according to Claim 18 on a covering film.

20. An interlayer adhesive prepared by laminating the resin film according to Claim 18 on a release film.

21. A metal-clad laminate for a printed circuit board prepared by laminating the resin film according to Claim 18 on a substrate or metal foil and then laminate-bonding the film with the metal foil or the substrate.

22. A multilayer printed circuit board prepared by removing the release film in the interlayer adhesive according to Claim 20 and then conducting laminate-bonding while said resin film is sandwiched between layers.
